# EUROPÄISCHE PATENTSCHRIFT

(11) **EP 3 321 972 B1**
(45) Veröffentlichungstag und Bekanntmachung des Hinweises auf die Patenterteilung: **15.01.2020**
(21) Anmeldenummer: 17001845.1
(22) Anmeldetag: 10.11.2017
(51) Int. Cl.: H01L 29/872, H01L 29/20, H01L 29/06, H01L 21/329, H01L 21/18

(54) **STAPELFÖRMIGE SCHOTTKY-DIODE**
STACKED SCHOTTKY DIODE
DIODE SCHOTTKY EMPILÉE

(30) Priorität: 14.11.2016 DE 102016013542
(43) Veröffentlichungstag der Anmeldung: 16.05.2018
(73) Patentinhaber: 3-5 Power Electronics GmbH, 01217 Dresden (DE)
(72) Erfinder: DUDEK, Volker, 76275 Ettlingen (DE)
(74) Vertreter: Koch Müller Patentanwaltsgesellschaft mbH

(56) Entgegenhaltungen:
- WO-A1-00/74130
- DE-A1- 4 036 222
- DE-A1-102015 204 138
- JP-A- 2005 045 212
- MORI M ET AL: "A novel soft and fast recovery diode (SFD) with thin p-layer formed by Al-Si electrode", POWER SEMICONDUCTOR DEVICES AND ICS, 1991. ISPSD '91., PROCEEDINGS OF THE 3RD INTERNATIONAL SYMPOSIUM ON BALTIMORE, MD, USA 22-24 APRIL 1, NEW YORK, NY, USA,IEEE, US, 22. April 1991 (1991-04-22), Seiten 113-117, XP010044304, DOI: 10.1109/ISPSD.1991.146079 ISBN: 978-0-7803-0009-5
- HADIZAD P ET AL: "High voltage GaAs rectifiers for high frequency, high power density switching applications", POWER MODULATOR SYMPOSIUM, 1996., TWENTY-SECOND INTERNATIONAL BOCA RATON, FL, USA 25-27 JUNE 1, NEW YORK, NY, USA,IEEE, US, 25. Juni 1996 (1996-06-25), Seiten 35-38, XP010205246, DOI: 10.1109/MODSYM.1996.564443 ISBN: 978-0-7803-3076-4

## Beschreibung

Die Erfindung betrifft eine stapelförmige Schottky-Diode.

Aus Josef Lutz et al, Semiconductor Power Devices, Springer Verlag, 2011, ISBN 978-3-642-11124-2, S. 238 sind hochsperrende Schottky-Dioden aus SiC bekannt.

Aus "GaAs Power Devices", Kapitel 3, S. 22- S. 26 von German Ashkinazi, ISBN 965-7094-19-4 ist eine Schottky-Diode mit einem GaAs umfassenden epitaktischen Schichtaufbau mit n⁺-Substrat und einer Nickel umfassenden Schicht zur Ausbildung des Schottky-Kontakts bekannt.

Weitere Schottky-Dioden sind aus der WO 00/74130 A1, der JP 2005 045212 A sowie aus "A novel soft and fast recovery diode (SFD) with thin p-layer formed by Al-Si electrode", Mori et al., POWER SEMICONDUCTOR DEVICES AND ICS, 1991. ISPSD '91., PROCEEDINGS OF THE 3RD INTERNATIONAL SYMPOSIUM ON BALTIMORE, MD, USA 22-24 APRIL 1991, NEW YORK, NY, USA,IEEE, US, 22 April 1991 (1991-04-22), pages 113-117, XP010044309, ISBN: 978-0-7803-0009-5, DOI: 10.1109/ISPSD.1991.146060 bekannt.

Insbesondere offenbart die WO 00/74310 A1 eine GaAs-basierte Schottkydiode, die einen Stapel aus zwei n-dotierten Halbleiterschichten und mehrere, jeweils zueinander beabstandete p-Bereiche umfasst, die als parallel zu der Oberseite der Diode verlaufende Rippen in der oberen n-dotierten Schicht und unterhalb der Schottkyelektrode ausgebildet sind. Die Kanten der viereckigen Schottkyelektrode verlaufen innerhalb eines Schutzrings.

Vor diesem Hintergrund besteht die Aufgabe der Erfindung darin, eine Vorrichtung anzugeben, die den Stand der Technik weiterbildet.

Die Aufgabe wird durch eine stapelförmige Schottky-Diode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Schottky-Diode bereitgestellt, aufweisend einen Stapel mit einer Oberseite und einer Unterseite.

Der Stapel umfasst wenigstens drei Halbleiterschichten und einer mit der Unterseite des Stapels stoffschlüssig verbundenen ersten Anschlusskontaktschicht und einer mit der Oberseite des Stapels verbundenen zweiten Anschlusskontaktschicht.

Die zweite Anschlusskontaktschicht umfasst ein Metall oder eine metallische Verbindung oder besteht aus einem Metall oder einer metallischen Verbindung, wobei die zweite Anschlusskontaktschicht einen Schottky-Kontakt aus-bildet, und wobei die zweite Anschlusskontaktschicht in einem Teilbereich der Oberseite angeordnet ist und die zweite Anschlusskontaktschicht von Kanten begrenzt ist.

An der Unterseite des Stapels ist eine erste als eine n+-Schicht ausgebildete Halbleiterschicht angeordnet, wobei die erste Halbleiterschicht eine Dotierstoffkonzentration von mindestens 10¹⁹ N/cm³ und eine Schichtdicke zwischen 50 µm und 400µm aufweist.

Die erste Halbleiterschicht umfasst eine GaAs-Verbindung oder besteht aus einer GaAs Verbindung.

Auf der ersten Halbleiterschicht ist eine zweite als eine n⁻-Schicht ausgebildete Halbleiterschicht angeordnet.

Die zweite Halbleiterschicht weist eine Dotierstoffkonzentration zwischen 10¹² und 10¹⁶ N/cm³ und eine Schichtdicke zwischen 10 µm und 300 µm auf und umfasst eine GaAs-Verbindung oder besteht aus einer GaAs Verbindung.

Auf der zweiten Halbleiterschicht ist eine dritte als eine p⁻-Schicht ausgebildete Halbleiterschicht angeordnet.

Die dritte Halbleiterschicht weist eine Dotierstoffkonzentration zwischen 10¹² und 10¹⁶ N/cm³ und eine Schichtdicke zwischen 10 nm und 10umauf und umfasst eine GaAs-Verbindung oder besteht aus einer GaAs Verbindung.

Der Stapel weist mehrere, jeweils zueinander beabstandete p⁺-Bereiche auf.

Die p⁺-Bereiche sind als parallel zu der Oberseite des Stapels verlaufende Rippen ausgebildet, und weisen eine Dotierstoffkonzentration von 5 • 10¹⁷-5 • 10²⁰ N/cm³ auf und reichen von der Oberseite des Stapels bis in die zweite Halbleiterschicht hinein.

Zwei parallel zu den p⁺-Bereichen verlaufende Kanten der zweiten Anschlusskontaktschicht verlaufen innerhalb von den p⁺-Bereichen.

Es sei angemerkt, dass die zweite Anschlusskontaktschicht als Anode und die erste Anschlusskontaktschicht als Kathode bezeichnet wird. Hierbei bildet die erste Anschlusskontaktschicht einen ohmschen Kontakt die zweite Anschlusskontaktschicht einen Metall- Halbleiterübergang aus.

Es versteht sich, dass auf den Anschlusskontaktschichten noch weitere Schichten ausbilden lassen, um beispielsweise die Schottky-Diode zu bonden.

Ein Vorteil ist, dass mittels der sehr dünnen niedrig dotierten p-Schicht als dritte Halbleiterschicht und den p⁺-Bereiche welche an den Kanten und vorzugsweise unterhalb der zweiten Kontaktanschlussschicht ausgebildet sind der Schottky-Kontakt vollständig von dem Durchgriff des hohen elektrischen Feldes abschirmen lässt. Hierzu sind die Rippen relativ nahe zusammen, sodass nur relativ schmale n⁻-Schichtbereiche zwischen benachbarten Rippen verbleiben.

Hierdurch lassen sich Sperrspannungen der Schottky-Diode in einem Bereich zwischen 200 V und 600 V und auch oberhalb von 600 V ohne weiteres erreichen. In Verbindung mit der von GaAs im Vergleich zu Silizium wesentlich kleineren effektiven Masse lassen sich schnelle Schaltzeiten erzielen.

Die erfindungsgemäße Schottky-Diode Damit eignet sich insbesondere als Freilaufdiode im Bereich der Leistungselektronik vorzugsweise bei Schaltnetzteilen und Umrichtern.

Die zweite Anschlusskontaktschicht ist viereckig ausgebildet und überdeckt vorzugsweise mehr als 30 %, höchst vorzugsweise mehr als 50 % der Fläche der Halbleiterschicht an der Oberseite des Stapels.

Der Stapel ist in einer alternativen Ausführungsform monolithisch ausgebildet. Monolithische Halbleiterstrukturen werden mittels epitaktischer Herstellungsverfahren, wie LPE oder MOVPE gefertigt.

In einer Weiterbildung sind die drei angegebenen Halbleiterschichten in der genannten Reihenfolge angeordnet und stoffschlüssig miteinander verbunden.

Die p⁺-Bereiche werden in einer weiteren Ausführungsform durch Implantation erzeugt sind, wobei zuvor mittels eines Maskenschrittes an der Oberseite alle Bereich außer den zu bildenden rippenförmigen Gebieten abgedeckt werden. Vorzugsweise beträgt der Abstand zwischen zwei unmittelbar benachbarten p⁺-Bereichen zwischen 3 um und 30µm.

In einer Ausführungsform sind wenigstens fünf zueinander beabstandete p⁺-Bereiche vorgesehen. Vorzugsweise sind die p⁺-Bereiche entlang den Kanten und unterhalb der zweiten Anschlusskontaktschicht angeordnet und weisen jeweils den gleichen Abstand zueinander auf. Die Anschlusskontaktschicht bedeckt bis auf die entlang den Kanten angeordneten Bereiche alle weiteren p⁺-Bereiche vollständig.

In einer Weiterbildung ist auf der dritten Halbleiterschicht eine vierte als eine n⁻-Schicht ausgebildete Halbleiterschicht angeordnet, wobei die vierte Halbleiterschicht eine Dotierstoffkonzentration zwischen von 10¹² N/cm³ und 10¹⁶ N/cm³ und eine Schichtdicke zwischen 0,005 µm und 10 µm aufweist und eine GaAs-Verbindung umfasst oder aus einer GaAs Verbindung besteht. Die vierte Halbleiterschicht ist an der Oberseite des Stapels ausgebildet und die p⁺-Bereiche erstrecken sich durch die vierte Halbleiterschicht hindurch.

In einer Ausführungsform bedeckt die zweite Kontaktschicht die Oberseite des Stapels nur teilweise. Vorzugsweise bedeckt die erste Kontaktschicht die Unterseite des Stapels vollständig oder bis auf einen schmalen Randbereich kleiner als 1 mm.

In einer weiteren Ausführungsform weist der stapelförmige Schichtaufbau bestehend aus der p⁻-Schicht, der n⁻-Schicht und der n⁺-Schicht ein zwischen der n⁻-Schicht und der p⁻-Schicht ausgebildeter Halbleiterbond auf. Es wird angemerkt, dass der Ausdruck Halbleiterbond synonym mit dem Ausdruck Waferbond verwendet wird. Der Schichtaufbau bestehend aus einem die p⁻-Schicht umfassenden ersten Teilstapel und aus einem die n⁺-Schicht und die n⁻-Schicht umfassenden zweiten Teilstapel. Der erste Teilstapel und der zweite Teilstapel sind jeweils monolithisch ausgebildet.

Vorzugsweise weist die p⁻-Schicht eine Dotierung kleiner als 10¹³ N/ cm³ oder eine Dotierung zwischen 10¹³ N/cm³ und 10¹⁵ N/cm³ auf. In einer Ausführungsform wird das p⁻-Schicht vor oder nach dem Bonden durch einen Schleifprozess auf eine Dicke zwischen 10 µm und 300 µm gedünnt.

In einer Ausführungsform ist ein erster Teilstapel vorgesehen, wobei der erste Teilstapel die p⁻-Schicht umfasst und des Weiteren ist ein zweiter Stapel vorgesehen, wobei der zweite Teilstapel die n⁻-Schicht und die n⁺-Schicht umfasst und der erste Teilstapel mit dem zweiten Stapel durch einen Waferbondprozess verbunden ist.

In einer anderen Ausführungsform wird der zweite Stapel gebildet, in dem ausgehend von einem n⁻-Substrat die n⁻-Schicht ausbilden lässt, wobei das n⁻ -Substrat bzw. die n⁻-Schicht mit dem zweiten Stapel durch einen Waferbondprozess verbunden wird oder ist. In einem weiteren Prozessschritt wird das n⁻-Substrat bzw. die n⁻-Schicht auf die gewünschte Dicke gedünnt. Vorzugsweise liegt die Dicke der n⁻-Schicht in einem Bereich zwischen 50 µm bis 250µm. Vorzugsweise liegt die Dotierung der n⁻-Schicht in einem Bereich zwischen 10¹³ N/cm³ und 10¹⁵ N/cm³. Ein Vorteil des Waferbonden ist es, dass sich dicke n⁻-Schichten ohne weiteres herstellen lassen. Ein langer Abscheideprozess bei der Epitaxie entfällt hierdurch. Auch lassen sich mittels des Bondens die Anzahl der Stapelfehler verringern.

In einer alternativen Ausführungsform weist die n⁻-Schicht eine Dotierung kleiner als 10¹³ N/cm³ auf. In dem die Dotierung extrem gering ist, lässt sich die n⁻-Schicht auch als eine intrinsische Schicht auffassen.

In einer Weiterbildung wird nach dem Dünnen des n⁻-Substrats bzw. der n⁻-Schicht mittels Epitaxie oder Hochdosisimplantation auf dem n⁻-Substrat bzw. der n⁻-Schicht die n⁺-Schicht in einem Bereich zwischen 10¹⁸ N/cm³ und kleiner als 5x10¹⁹ N/cm³ erzeugt. Das Dünnen des n⁻-Substrats bzw. der n⁻-Schicht erfolgt vorzugsweise mittels eines CMP Schrittes, d.h. mittels chemischen mechanischen Polierens.

In einer anderen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen Weiterbildung wird anschließend die Vorderseite abgelöst.

In einer Ausführungsform werden die Oberfläche der n⁺-Schicht und die Oberfläche der p⁻-Schicht metallisiert, um die Schottky-Diode auszubilden und elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p⁻-Schicht ausgebildet.

Untersuchungen haben gezeigt, dass sich mit bestimmten Kombinationen von einer p⁻-Zwischenschicht und n⁻-Schicht verschiedene Sperrspannungen erzielen lassen. Bei den folgenden Varianten handelt es sich nicht um Ausführungsformen der vorliegenden Erfindung.

In einer ersten Variante umfasst die:
p⁻- Zwischenschicht eine Dicke zwischen 10 µm bis 25 µm und für die n⁻-Schicht eine Dicke zwischen 40 µm und 90 µm eine Sperrspannung von ca. 900 V ergibt.

In einer zweiten Variante umfasst die:
p⁻- Zwischenschicht eine Dicke zwischen 25 µm bis 25 µm und für die n⁻-Schicht eine Dicke zwischen 40 µm und 70 µm eine Sperrspannung von ca. 1200 V ergibt.

In einer dritten Variante umfasst die:
p⁻- Zwischenschicht eine Dicke zwischen 35 µm bis 50 µm und für die n⁻-Schicht eine Dicke zwischen 70µm und 150 µm und 70 µm eine Sperrspannung von ca. 1500 V ergibt.

Die Dioden in der ersten bis dritten Variante lassen sich hinsichtlich der Ausbildung der Raumladungszonen auch als Punsch- Dioden bezeichnen.

In einer vierten Variante umfasst die:
p⁻- Zwischenschicht eine Dicke zwischen 10 µm bis 25 µm und für die n⁻-Schicht eine Dicke zwischen 60 µm und 110 µm.

In einer fünften Variante umfasst die:
p⁻- Zwischenschicht eine Dicke zwischen 10 µm bis 25 µm und für die n⁻-Schicht eine Dicke zwischen 70 µm und 140.

In einer sechsten Variante umfasst die:
p⁻- Zwischenschicht eine Dicke zwischen 35 µm bis 50 µm und für die n⁻-Schicht eine Dicke zwischen 80µm und 200 µm.

Die Dioden in der vierten bis sechsten Variante lassen sich hinsichtlich der Ausbildung der Raumladungszonen auch als "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine schematische Ansicht auf eine erste erfindungsgemäße Ausführungsform einer stapelförmigen Schottky-Diode,
- Figur 2: eine schematische Ansicht auf eine zweite erfindungsgemäße Ausführungsform eines Stapels einer stapelförmigen Schottky-Diode,
- Figur 3: eine schematische Ansicht auf eine dritte erfindungsgemäße Ausführungsform einer stapelförmigen SchottkyDiode,
- Figur 4: eine Aufsicht auf die Ausführungsform der erfindungsgemäße Schottky-Diode der Figur 3.

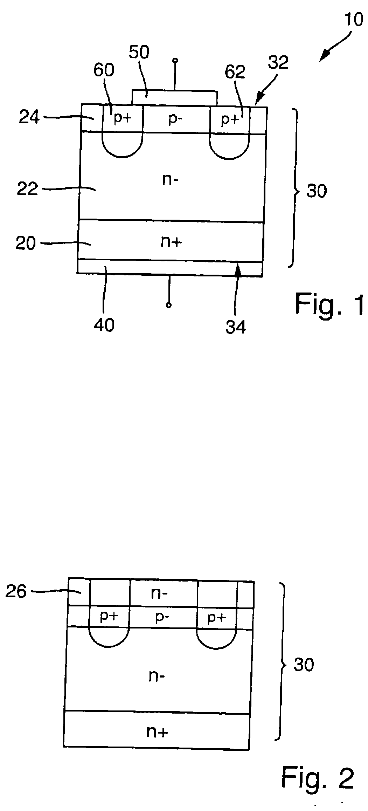

Die Abbildung der Figur 1 zeigt eine Ansicht einer ersten Ausführungsform, stapelförmige Schottky-Diode 10 aufweisend einen aus mindestens drei Halbleiterschichten 20, 22, 24 bestehenden Stapel 30 mit einer Oberseite 32 und einer Unterseite 34, einen mit der Unterseite 34 des Stapels 30 stoffschlüssig verbundenen ersten Anschlusskontaktschicht 40 und eine mit einem Teilbereich der Oberseite 34 des Stapels stoffschlüssig verbundene metallische zweite Anschlusskontaktschicht 50 zur Ausbildung eines Schottky-Kontakts.

Die erste Halbleiterschicht 20 des Stapels 30 ist als eine n⁺-Schicht und ist an der Unterseite 34 des Stapels 30 angeordnet und weist eine Dotierstoffkonzentration von mindestens 10¹⁹ cm⁻³ und eine Schichtdicke zwischen 50 µm und 400 µm auf.

Die zweite Halbleiterschicht 22 des Stapels 30 ist auf der ersten Halbleiterschicht 20 angeordnet und ist stoffschlüssig mit der ersten Halbleiterschicht 20 verbunden.

Die zweite Halbleiterschicht 22 ist als eine n⁻-Schicht ausgebildet und weist eine Dotierstoffkonzentration in einem Bereich von 10¹² bis 10¹⁶ cm⁻³ und einer Schichtdicke von 10 µm-300 µm auf.

Die dritte Halbleiterschicht 24 des Stapels 30 ist als p⁻-Schicht ausgebildet und stoffschlüssig mit der zweiten Halbleiterschicht 22 verbunden. Die dritte Halbleiterschicht 24 weist eine Dotierstoffkonzentration in einem Bereich von 10¹²-10¹⁶ cm⁻³ und einer Schichtdicke von 0,01 µm - 10µm auf.

Alle drei Halbleiterschichten 20, 22, 24 umfassend eine GaAs-Verbindung.

Der Stapel 30 weist zusätzlich zwei p⁺-Bereiche 60, 62 auf. Die beiden p⁺-Bereiche 60, 62 weisen jeweils eine Dotierstoffkonzentration von 5•10¹⁸-5•10²⁰cm⁻³ auf und sind als zueinander beabstandete Rippen ausgebildet, wobei sich jeder p⁺-Bereich 60, 62, also jede Rippe, in eine Richtung senkrecht zu der Oberseite 32 des Stapels 30 von der Oberseite 32 des Stapels 30 bis in die n⁻-Schicht 22 hinein erstreckt und in einer ersten Richtung parallel zu der Oberseite 32 des Stapels 30 einen Streifen bildet.

Zur Ausbildung des Schottky-Kontakts überdeckt die zweite Anschlusskontaktschicht 50 einen Teil der Oberseite 32 des Stapels 30, wobei der Teil einen zwischen den beiden p⁺-Bereichen 60, 62 befindlichen ersten Oberflächenbereich sowie jeweils nur einen an den ersten Oberflächenbereich angrenzenden Teilbereich der beiden p⁺-Bereiche umfasst und die zweite Anschlusskontaktschicht 50 stoffschlüssig mit der dritten Halbleiterschicht 24 verbunden ist.

In der Abbildung der Figur 2 ist eine weitere Ausführungsform eines Stapels 30 einer erfindungsgemäßen Schottky-Diode 10 dargestellt. Im Folgenden werden nur die Unterschiede zu der Abbildung der Figur 1 erläutert.

Der Stapel 30 weist eine vierte Halbleiterschicht 26 auf. Die vierte Halbleiterschicht 26 ist als eine n⁻-Schicht mit einer Dotierstoffkonzentration von 10¹²-10¹⁶ cm⁻³ und einer Schichtdicke von 0,005 µm bis 10 µm ausgebildet und umfasst ebenfalls eine GaAs-Verbindung.

Die n⁻-Schicht ist mit der darunterliegenden p⁻-Schicht stoffschlüssig verbundenen und bildet die Oberseite des Stapels aus. Die p⁺-Bereich erstrecken sich jeweils durch die n⁻-Schicht.

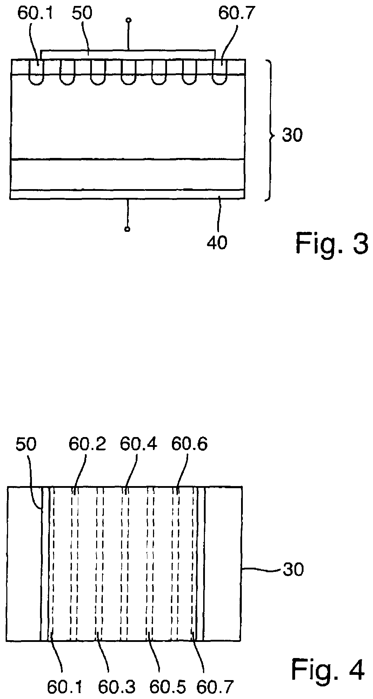

In den Abbildungen der Figuren 3 und 4 ist eine weitere Ausführungsform einer erfindungsgemäßen Schottky-Diode 10 als seitliche Ansicht bzw. als Aufsicht dargestellt. Im Folgenden werden nur die Unterschiede zu der Abbildung der Figur 1 erläutert.

Die Schottky-Diode weist sieben jeweils zueinander beabstandete, rippenförmige p⁺-Bereiche 60.1-60.7 auf. Der zur Ausbildung eines Schottky-Kontakts mit der zweiten Anschlusskontaktschicht 50 stoffschlüssig verbundene Teil der Oberfläche 32 erstreckt sich von dem ersten p⁺-Bereich 60.1 bis zu dem siebten p⁺-Bereich 60.7, wobei der erste p⁺-Bereich 60.1 und der siebte p⁺-Bereich 60.7 jeweils nur teilweise von der Metall-Schicht überdeckt sind.

## Patentansprüche

1. Stapelförmige Schottky-Diode (10), aufweisend
einen Stapel (30) mit einer Oberseite (32) und einer Unterseite (34), wobei der Stapel (30) wenigstens drei Halbleiterschichten (20, 22, 24) umfasst,
- eine mit der Unterseite (32) des Stapels (30) stoffschlüssig verbundenen ersten Anschlusskontaktschicht (40) und
- eine mit der Oberseite des Stapels (30) verbundenen zweiten Anschlusskontaktschicht (50), wobei die zweite Anschlusskontaktschicht (50) ein Metall oder eine metallische Verbindung umfasst oder aus einem Metall oder einer metallischen Verbindung besteht und einen Schottky-Kontakt ausbildet,
wobei die zweite Anschlusskontaktschicht (50) in einem Teilbereich der Oberseite (34) angeordnet ist und die zweite Anschlusskontaktschicht (50) viereckig ausgebildet ist,
- an der Unterseite des Stapels eine erste als eine n⁺-Schicht ausgebildete Halbleiterschicht (20) angeordnet ist und die erste Halbleiterschicht (20) eine Dotierstoffkonzentration von mindestens 10¹⁹ N/cm³ und eine Schichtdicke zwischen 50µm und 400 µm aufweist und die erste Halbleiterschicht (20) eine GaAs-Verbindung umfasst oder aus einer GaAs Verbindung besteht,
- auf der ersten Halbleiterschicht (20) eine zweite als eine n⁻-Schicht ausgebildete Halbleiterschicht (22) angeordnet ist und die zweite Halbleiterschicht (22) eine Dotierstoffkonzentration zwischen 10¹² und 10¹⁶ N /cm³ und eine Schichtdicke zwischen 10 µm und 300 µm aufweist und die zweite Halbleiterschicht (22) eine GaAs-Verbindung umfasst oder aus einer GaAs Verbindung besteht,
- auf der zweiten Halbleiterschicht (22) eine dritte als eine p⁻-Schicht ausgebildete Halbleiterschicht (24) angeordnet ist und die dritte Halbleiterschicht (24) eine Dotierstoffkonzentration zwischen 10¹² und 10¹⁶ N /cm³ und eine Schichtdicke zwischen 10 nm und 10um aufweist und die dritte Halbleiterschicht (24) eine GaAs-Verbindung umfasst oder aus einer GaAs Verbindung besteht,
- der Stapel (30) monolithisch ausgebildet ist oder der Stapel (30) zwischen der zweiten Halbleiterschicht (22) und der dritten Halbleiterschicht (24) einen Halbleiterbond aufweist,
- der Stapel (30) mehrere, jeweils zueinander beabstandete p⁺-Bereiche (60, 62; 60.1-60.7) aufweist und die p⁺-Bereiche (60, 62; 60.1-60.7) als parallel zu der Oberseite (32) des Stapels (30) verlaufende Rippen ausgebildet sind,
- die p⁺-Bereiche (60, 62; 60.1-60.7) eine Dotierstoffkonzentration von 5 • 10¹⁸-5 • 10²⁰ N / cm⁻³ aufweisen, und
- die p⁺-Bereiche (60, 62; 60.1-60.7) von der Oberseite (32) des Stapels (30) bis in die zweite Halbleiterschicht (22) hineinreichen,
- zwei parallel zu den p⁺-Bereichen verlaufende Kanten der zweiten Anschlusskontaktschicht (50) innerhalb von p⁺-Bereichen (60, 60.1- 60.7, 62) verlaufen.

2. Schottky-Diode (10) nach Anspruch 1, **dadurch gekennzeichnet, dass** die drei Halbleiterschichten (20, 22, 24) in der angegebenen Reihenfolge angeordnet und stoffschlüssig miteinander verbunden sind.

3. Schottky-Diode (10) nach Anspruch 1 oder Anspruch 2, **dadurch gekennzeichnet, dass** eine auf der dritten Halbleiterschicht (24) eine vierte als eine n⁻-Schicht ausgebildete Halbleiterschicht (26) angeordnet ist und die vierte Halbleiterschicht (26) eine Dotierstoffkonzentration zwischen von 10¹² N/cm³ und 10¹⁶ N/cm³ und eine Schichtdicke zwischen 0,005 µm und 10 µm aufweist und die vierte Halbleiterschicht (20) eine GaAs-Verbindung umfasst oder aus einer GaAs Verbindung besteht und die vierte Halbleiterschicht (26) an der Oberseite (32) des Stapels (30) ausgebildet ist und sich die p⁺-Bereiche (60, 62; 60.1-60.7) durch die vierte Halbleiterschicht (26) erstrecken.

4. Schottky-Diode (10) nach einem der Ansprüche 1 bis 4, **dadurch gekennzeichnet, dass** die p⁺-Bereiche (60, 62; 60.1-60.7) mittels einer IonenImplantation erzeugt sind.

5. Schottky-Diode (10) nach einem der Ansprüche 1 bis 5, **dadurch gekennzeichnet, dass** p⁺-Bereiche (60, 62; 60.1-60.7) untereinander Abstände in einem Bereich zwischen 3 µm bis 30 µm aufweisen.

6. Schottky-Diode (10) nach einem der Ansprüche 1 bis 6, **dadurch gekennzeichnet, dass** die Schottky-Diode (10) mindestens fünf zueinander beabstandete p⁺-Bereiche (60, 62; 60.1-60.7) aufweist.

7. Schottky-Diode (10) nach einem der Ansprüche 1 bis 7, **dadurch gekennzeichnet, dass** die p⁺-Bereiche (60, 62; 60.1-60.7) entlang den Kanten und unterhalb der zweiten Anschlusskontaktschicht (50) angeordnet sind und die Rippen jeweils den gleichen Abstand zueinander aufweisen.

8. Schottky-Diode (10) nach einem der Ansprüche 1 bis 8, **dadurch gekennzeichnet, dass** die zweite Kontaktschicht die Oberseite (32) des Stapels (30) nur teilweise bedeckt und / oder die erste Kontaktschicht (40) die Unterseite (34) des Stapels (30) vollständig oder bis auf einen schmalen Randbereich kleiner als 1 mm bedeckt.

## Claims

1. Stack-shaped Schottky diode (10), comprising
a stack (30) with an upper side (32) and a lower side (34),
wherein the stack (30) comprises at least three semiconductor layers (20, 22, 24),
- a first terminal contact layer (40) connected by material couple with the lower side (32) of the stack (30) and
- a second terminal contact layer (50) connected with the upper side of the stack (30), wherein the second terminal contact layer (50) comprises a metal or a metallic compound or consists of a metal or a metallic compound and forms a Schottky contact and wherein the second terminal contact layer (50) is arranged in a subregion of the upper side (34) and the second terminal contact layer (50) is of four-cornered configuration,
- a first semiconductor layer (20) constructed as an n⁺ layer is arranged at the lower side of the stack and the first semiconductor layer (20) has a doping substance concentration of at least 10¹⁹ N/cm³ and a layer thickness between 50 µm and 400 µm and the first semiconductor layer (20) comprises a GaAs compound or consists of a GaAs compound,
- a second semiconductor layer (22) constructed as a n⁻ layer is arranged on the first semiconductor layer (20) and the second semiconductor layer (22) has a doping substance concentration between 10¹² and 10¹⁶ N/cm³ and a layer thickness between 10 µm and 300 µm and the second semiconductor layer (22) comprises a GaAs compound or consists of a GaAs compound,
- a third semiconductor layer (24) constructed as a p⁻ layer is arranged on the second semiconductor layer (22) and the third semiconductor layer (24) has a doping substance concentration between 10¹² and 10¹⁶ N/cm³ and a layer thickness between 10 nm and 10 um and the third semiconductor layer (24) comprises a GaAs compound or consists of a GaAs compound,
- the stack (30) is of monolithic construction or the stack (30) has a semiconductor bond between the second semiconductor layer (22) and the third semiconductor layer (24),
- the stack (30) comprises a plurality of mutually spaced-apart p⁺ regions (60, 62; 60.1 - 60.7) and the p⁺ regions (60, 62; 60.1 - 60.7) are constructed as ribs extending parallel to the upper side (32) of the stack (30),
- the p⁺ regions (60, 62; 60.1 - 60.7) have a doping substance concentration of 5 • 10¹⁸ to 5 • 10²⁰ N/cm³, and
- the p⁺ regions (60, 62; 60.1 - 60.7) reach from the upper side (32) of the stack (30) as far as into the second semiconductor layer (22),
- two edges, which extend parallel to the p⁺ regions, of the second terminal contact layer (50) extend within the p⁺ regions (60, 60.1 - 60.7, 62).

2. Schottky diode (10) according to claim 1, **characterised in that** the three semiconductor layers (20, 22, 24) are arranged in the indicated sequence and connected together by material couple.

3. Schottky diode (10) according to claim 1 or claim 2, **characterised in that** a fourth semiconductor layer (26) constructed as a n⁻ layer is arranged on the third semiconductor layer (24) and the fourth semiconductor layer (26) has a doping substance concentration between 10¹² N/cm³ and 10¹⁶ N/cm³ and a layer thickness between 0.005 µm and 10 µm and the fourth semiconductor layer (20) comprises a GaAs compound or consists of a GaAs compound and the fourth semiconductor layer (26) is formed at the upper side (32) of the stack (30) and the p⁺ regions (60, 62; 60.1 - 60.7) extend through the fourth semiconductor layer (26).

4. Schottky diode (10) according to any one of claims 1 to 4, **characterised in that** the p⁺ regions (60, 62; 60.1 - 60.7) are produced by means of ion implantation.

5. Schottky diode (10) according to any one of claims 1 to 5, **characterised in that** p⁺ regions (60, 62; 60.1 - 60.7) have mutual spacings in a range between 3 µm and 30 µm.

6. Schottky diode (10) according to any one of claims 1 to 6, **characterised in that** the Schottky diode (10) has at least five mutually spaced-apart p⁺ regions (60, 62; 60.1 - 60.7).

7. Schottky diode (10) according to any one of claims 1 to 7, **characterised in that** the p⁺ regions (60, 62; 60.1 - 60.7) are arranged along the edges and below the second terminal contact layer (50) and the ribs have the same spacing from one another.

8. Schottky diode (10) according to any one of claims 1 to 8, **characterised in that** the second contact layer only partly covers the upper side (32) of the stack (30) and/or the first contact layer (40) covers the lower side (34) of the stack (30) completely or apart from a narrow edge region less than 1 mm.

## Revendications

1. Diode Schottky empilée (10), présentant
- un empilement (30) avec un côté supérieur (32) et un côté inférieur (34), dans laquelle l'empilement (30) comprend au moins trois couches semi-conductrices (20, 22, 24),
- une première couche de contact de raccordement (40) reliée matériellement au côté inférieur (32) de l'empilement (30),
- une deuxième couche de contact de raccordement (50) reliée au côté supérieur de l'empilement (30), dans laquelle la deuxième couche de contact de raccordement (50) comprend un métal ou un composé métallique ou est constituée d'un métal ou d'un composé métallique et forme un contact Schottky, dans laquelle la deuxième couche de contact de raccordement (50) est disposée dans une région partielle du côté supérieur (34) et la deuxième couche de contact de raccordement (50) est de forme quadrangulaire,
- une première couche semi-conductrice (20) formée par une couche n+ est disposée sur le côté inférieur de l'empilement et la première couche semi-conductrice (20) présente une concentration de dopant d'au moins 10¹⁹ N/cm³ et une épaisseur de couche comprise entre 50 µm et 400 µm et la première couche semi-conductrice (20) comprend un composé GaAs ou est constituée d'un composé GaAs,
- une deuxième couche semi-conductrice (22) formée par une couche n- est disposée sur la première couche semi-conductrice (20) et la deuxième couche semi-conductrice (22) présente une concentration de dopant comprise entre 10¹² et 10¹⁶ N/cm³ et une épaisseur de couche comprise entre 10 µm et 300 µm et la deuxième couche semi-conductrice (22) comprend un composé GaAs ou est constituée d'un composé GaAs,
- une troisième couche semi-conductrice (24) formée par une couche p- est disposée sur la deuxième couche semi-conductrice (22) et la troisième couche semi-conductrice (24) présente une concentration de dopant comprise entre 10¹² et 10¹⁶ N/cm³ et une épaisseur de couche comprise entre 10 nm et 10 µm et la troisième couche semi-conductrice (24) comprend un composé GaAs ou est constituée d'un composé GaAs,
- l'empilement (30) est monolithique ou l'empilement (30) présente un lien semiconducteur entre la deuxième couche semi-conductrice (22) et la troisième couche semi-conductrice (24),
- l'empilement (30) présente plusieurs régions p+ respectivement espacées l'une de l'autre (60, 62; 60.1-60.7) et les régions p+ (60, 62; 60.1-60.7) sont réalisées sous forme de nervures s'étendant parallèlement au côté supérieur (32) de l'empilement (30),
- les régions p+ (60, 62; 60.1-60.7) présentent une concentration de dopant de 5^{∗}10¹⁸ - 5^{∗}10²⁰ N/cm⁻³, et
- les régions p+ (60, 62; 60.1-60.7) s'étendent du côté supérieur (32) de l'empilement (30) jusque dans la deuxième couche semi-conductrice (22),
- deux bords de la deuxième couche de contact de raccordement (50) s'étendant parallèlement aux régions p+ s'étendent dans des régions p+ (60, 60.1-60.7, 62).

2. Diode Schottky (10) selon la revendication 1, **caractérisée en ce que** les trois couches semi-conductrices (20, 22, 24) sont disposées dans l'ordre indiqué et sont reliées l'une à l'autre par une liaison matérielle.

3. Diode Schottky (10) selon la revendication 1 ou la revendication 2, **caractérisée en ce qu'**une quatrième couche semi-conductrice (26) formée par une couche n- est disposée sur la troisième couche semi-conductrice (24) et la quatrième couche semi-conductrice (26) présente une concentration de dopant comprise entre 10¹² N/cm³ et 10¹⁶ N/cm³ et une épaisseur de couche comprise entre 0,005 µm et 10 µm et la quatrième couche semi-conductrice (20) comprend un composé GaAs ou est constituée d'un composé GaAs et la quatrième couche semi-conductrice (26) est formée sur le côté supérieur (32) de l'empilement (30) et les régions p+ (60, 62; 60.1-60.7) s'étendent à travers la quatrième couche semi-conductrice (26).

4. Diode Schottky (10) selon l'une quelconque des revendications 1 à 4, **caractérisée en ce que** les régions p+ (60, 62; 60.1-60.7) sont produites au moyen d'une implantation d'ions.

5. Diode Schottky (10) selon l'une quelconque des revendications 1 à 5, **caractérisée en ce que** des régions p+ (60, 62; 60.1-60.7) présentent entre elles des distances comprises dans une plage de 3 µm à 30 µm.

6. Diode Schottky (10) selon l'une quelconque des revendications 1 à 6, **caractérisée en ce que** la diode Schottky (10) présente au moins cinq régions p+ (60, 62; 60.1-60.7) distantes l'une de l'autre.

7. Diode Schottky (10) selon l'une quelconque des revendications 1 à 7, **caractérisée en ce que** les régions p+ (60, 62; 60.1-60.7) sont disposées le long des bords et en dessous de la deuxième couche de contact de raccordement (50) et les nervures présentent chaque fois la même distance l'une de l'autre.

8. Diode Schottky (10) selon l'une quelconque des revendications 1 à 8, **caractérisée en ce que** la deuxième couche de contact ne recouvre que partiellement le côté supérieur (32) de l'empilement (30) et/ou la première couche de contact (40) recouvre le côté inférieur (34) de l'empilement (30) entièrement ou jusqu'à une étroite bande de bord inférieure à 1 mm.
